**Europäisches Patentamt**

**European Patent Office**

**Office européen des brevets**

(19)

(11) Veröffentlichungsnummer: **0 372 228**

**A1**

(12) ## EUROPÄISCHE PATENTANMELDUNG

(21) Anmeldenummer: **89120447.1**

(22) Anmeldetag: **04.11.89**

(51) Int. Cl.5: **H01L 25/07**

Die Bezeichnung der Erfindung wurde geändert (Richtlinien für die Prüfung im EPA, A-III, 7.3).

(30) Priorität: **09.11.88 DE 3837920**

(43) Veröffentlichungstag der Anmeldung:
**13.06.90 Patentblatt 90/24**

(84) Benannte Vertragsstaaten:
**CH DE FR GB IT LI SE**

(71) Anmelder: **SEMIKRON ELEKTRONIK GMBH**
**Sigmundstrasse 200 Postfach 82 02 51**
**D-8500 Nürnberg 82(DE)**

(72) Erfinder: **Heilbronner, Heinrich, Dr.-Ing.**
**Birkenweg 6**
**D-8504 Stein(DE)**
Erfinder: **Tursky, Werner, Dr.**
**Georg-Kraft-Strasse 7**
**D-8540 Schwabach(DE)**

(54) **Halbleiterelement mit einer Trägerplatte.**

(57) Bekannte Bauformen von Halbleiterelementen oder von Baueinheiten mit Halbleiterelementen zeigen aufgrund der Benutzung von Kontaktplatten aus hochschmelzendem Metall hohen Material- und Verfahrensaufwand sowie ein nicht allen Anwendungsfällen genügendes thermisches Betriebsverhalten.

Das neue Halbleiterelement soll optimal niedrigen Wärmewiderstand, Beständigkeit gegen Wechselbelastung aufweisen und eine Minimum an Verfahrensschritten erfordern.

Bei dem Halbleiterelement ist der Halbleiterkörper (6) auf einer Trägerplatte mit gegenüber dem Halbleiterkörper größerer Flächenausdehnung durch Löten befestigt, die Trägerplatte ist wenigstens in einem sich über den Halbleiterkörper hinaus erstreckenden Bereich der den Halbleiterkörper tragenden Fläche zur Stromleitung ausgebildet, und der Halbleiterkörper ist unmittelbar auf dem zur Stromleitung ausgebildeten Bereich befestigt. Als Trägerplatte (3) kann eine metallische Platte, eine metallisierte Keramik oder eine Kombination aus metallischer Grundplatte (1) und darauf durch Löten befestigter Keramik vorgesehen sein.

Das Halbleiterelement betrifft alle Bereiche der Leistungselektronik.

Fig.1

EP 0 372 228 A1

## Halbleiterelement

Die Erfindung betrifft ein Halbleiterelement mit den Merkmalen nach dem Oberbegriff des Anspruchs 1.

Bei lötkontaktierten Halbleiteranordnungen hoher Strombelastbarkeit für die Leistungselektronik wird bekanntlich wenigstens auf der dem zugeordneten Kühlbauteil zugewandten Seite des großflächigen Halbleiterkörpers zwischen diesem und dem anschließenden Stromleitungsanschluß eine Kontaktplatte aus hochschmelzendem Metall und mit einem, demjenigen des Halbleitermaterials angepaßten Wärmeausdehnungskoeffizienten angeordnet. Damit soll weitgehend verhindert werden, daß infolge unterschiedlicher Wärmeausdehnung aneinandergrenzender Materialien bei wechselnden Betriebstemperaturen auftretende Schub- und Scherkräfte zur Zerstörung der Lötkontaktschichten und damit zum Ausfall des Halbleiterelements führen.

Die Kontaktplatte, vorzugsweise aus Molybdän, weist eine etwas geringere Flächenausdehnung als der Halbleiterkörper auf. Die Randzone des letzteren ist bei Forderung nach hoher Sperrspannungsbelastbarkeit mit einer entsprechenden Anschrägung versehen und am Austritt des oder der pn-Übergänge an die Oberfläche mit einem passivierenden und stabilisierenden Überzug abgedeckt. Aufgrund der Bemessung der aneinandergrenzenden Bauteile eines solchen Aufbaus wird mit der Verwendung einer Kontaktplatte auch eine Erhöhung der Überschlagsfestigkeit zwischen Teilen unterschiedlichen elektrischen Potentials erreicht.

Derartige Anordnungen sind z.B. bei Halbleiter-Baueinheiten in Kompaktbauweise, sogenannten Leistungs-Halbleitermodulen, in Anwendung und über eine Keramik potentialfrei auf gemeinsamer Grundplatte . aufgebracht. Mit solchen Aufbauten sind verschiedene Nachteile verbunden. Die Kontaktplatte aus hochschmelzendem Metall erhöht den Materialaufwand und erfordert zur Lötkontaktierung noch eine Oberflächenbehandlung. Da sie in den Bauteilestapel eingefügt ist, bewirkt sie wegen ihrer Bauhöhe und der zusätzlichen Lötkontaktschicht mit ungünstigen thermischen Eigenschaften einen höheren Widerstand für die aus dem Halbleiterkörper abzuleitende Verlustwärme. Weiter kann sich durch mangelhafte Oberflächenbehandlung und/oder nicht einwandfreie Lotverbindung die Ausfallrate erhöhen.

Für Bauformen mit Kontaktplatte wird jedoch gerade bezüglich ihrer mechanisch stabilen Anordnung auf einer metallischen Grundplatte und über diese stoffschlüssig auf einem Kühlbauteil eine umfangreiche und aufwendige Schichtenstruktur als erforderlich erachtet, um sowohl aufwendige Nacharbeit beim Herstellen als auch einen Ausfall durch unzulässige mechanische Spannungen beim Einsatz zu vermeiden. Dazu hat sich eine Metallplatte zwischen Grundplatte und Keramik, aus dem Grundplattenmaterial und beidseitig über Lötmetallschichten aus duktilem, höher schmelzendem Weichlot befestigt, als besonders zweckmäßig erwiesen. Jedoch sind damit zusätzliche Material- und Verfahrenskosten verbunden. Außerdem besteht wegen der Notwendigkeit mehrerer Lötprozesse das Risiko einer Beeinträchtigung der physikalischen Eigenschaften des Halbleitermaterials durch höhere Verfahrenstemperaturen.

Kontaktplatten zu dem vorgenannten zweck werden bei Halbleitergleichrichteraufbauten und bei Halbleiter-Schaltungsanordnungen mit Halbleiterkörpern ab etwa 5 cm$^2$ aktiver Fläche aufwärts bis zu größten Abmessungen verwendet.

Aufgrund der mechanisch geschützten und stabilen sowie annähernd spannungsfreien Befestigung von Halbleiterkörpern zwischen Kontaktplatten wurden in der Halbleitertechnik über einen großen Zeitraum hinweg allgemein die mit Kontaktplatten verbundenen Nachteile in Kauf genommen.

Der Erfindung liegt die Aufgabe zugrunde, eine lötkontaktierte Halbleiteranordnung hoher Strombelastbarkeit mit wenigstens einem Halbleiterkörper anzugeben, deren Aufbau optimal niedrigen Wärmewiderstand für die abzuleitende Verlustwärme aufweist, gegen Wechselbelastung beständig ist und ein Minimum an Verfahrensschritten erfordert.

Untersuchungen haben überraschend ergeben, daß lötkontaktierte Halbleiteranordnungen ohne Kontaktplatte bei entsprechender Bemessung der an der Ableitung der Verlustwärme beteiligten Schichten und Kontaktteile, mit entsprechender Materialvorgabe und mit reduzierter Teilefolge den bekannten aufwendigen Ausführungsformen gleichkommen.

Die Lösung der Aufgabe besteht bei einem Halbleiterelement der eingangs genannten Art in kennzeichnenden Merkmalen des Anspruchs 1. Vorteilhafte Ausgestaltungen der Erfindung sind in den Ansprüchen 2 bis 6 angegeben.

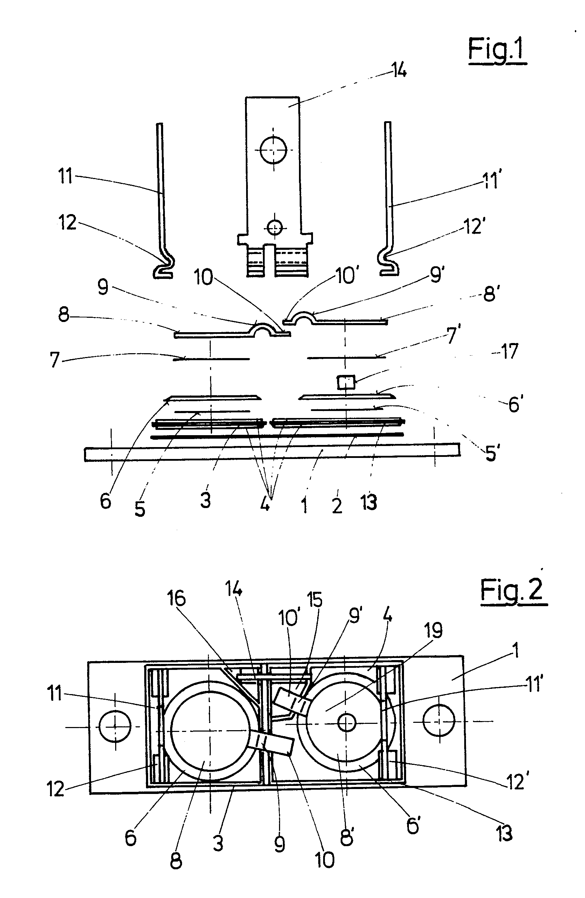

Anhand des in der Zeichnung dargestellten Ausführungsbeispiels wird die Erfindung erläutert. Figur 1 zeigt in Explosivdarstellung und Figur 2 in Draufsicht den ungekapselten Aufbau eines zwei Halbleiterkörper aufweisenden Leistungsmoduls. Für gleiche Teile sind in beiden Figuren gleiche Bezeichnungen gewählt.

Gemäß Figur 1 sind auf einer metallischen Grundplatte (1), vorzugsweise aus Kupfer, jeweils über eine elektrisch isolierende und thermisch gut leitende Isolierstoff-Zwischenscheibe (3, 13) zwei Halbleiterkörper angeordnet. Der Halbleiterkörper des links in der Figur gezeigten Aufbaus ist mit (6), der Halbleiterkörper des übereinstimmenden rechten Aufbaus mit (6') bezeichnet. Diese Unterscheidung ist mit Ausnahme der Isolierstoff-Zwischenscheiben, welche unterschiedlich ausgebildet sind, für gleiche Bauteile in beiden Aufbauten getroffen. Die Zwischenscheiben (3, 13) bestehen aus einer Keramik, z.B. aus Aluminiumoxid oder Aluminiumnitrid, und weisen an jeder ihrer Hauptflächen je eine Metallisierung (4) auf. Sie sind mittels einer unteren Lotmetallschicht (2) mit der Grundplatte (1) und mittels einer oberen Lotmetallschicht (5, 5') unmittelbar mit dem jeweiligen Halbleiterkörper (6, 6') verbunden. Die Keramik kann auch mit einer aufgebondeten Metallisierung aus Kupfer beschichtet sein.

Die Isolierzwischenscheiben (3, 13) sind im Vergleich zu Aufbauten mit Kontaktplatte im wesentlichen ganzflächig metallisiert. Die Metallisierung (4) dient gleichzeitig auch als Leiterbahn zur elektrischen Verbindung der unteren Hauptfläche des jeweiligen Halbleiterkörpers (6, 6') mit einem am Zwischenscheibenrand angebrachten Stromleitungsanschluß (11, 11'). Dieser ist zum Ausgleich von thermisch bedingten, mechanischen Spannungen mit wenigstens einem Dehnungsbogen (12, 12') versehen. Auf der oberen Hauptfläche jedes Halbleiterkörpers (6, 6') ist ein oberes Kontaktstück (8, 8') vorgesehen, welches ebenfalls durch Löten mittels Folie (7, 7') befestigt ist. Das obere Kontaktstück (8, 8') deckt die Elektrodenfläche der Halbleiterkörper (6, 6') im wesentlichen vollständig ab. Zur Durchführung eines z.B. im Zentrum der Halbleiterkörper erforderlichen Steuerelektrodenanschlusses (19) für Aufbauten mit Thyristoren ist eine entsprechende, nicht dargestellte Aussparung im oberen Kontaktstück (8, 8') vorgesehen, in welches ein Isolierröhrchen (17) eingesetzt ist. Beide Hälften des Ausführungsbeispiels sind im wesentlichen übereinstimmend ausgebildet.

Die im Aufbau gemäß Figur 1 vorgesehenen Halbleiterkörper (6, 6') sind elektrisch in Reihe geschaltet. Bei übereinstimmender elektrischer Anordnung auf der Grundplatte (1) ist die obere Kontaktelektrode des einen - hier des linken (6) - mit der unteren Kontaktelektrode des anderen - hier des rechten (6') -Halbleiterkörpers fest verbunden. Dazu dient gemäß der Darstellung der stegförmige Ansatz (9) des oberen Kontaktstücks (8) des linken Halbleiterkörpers (6). Er endet anschließend an einen Dehnungsbogen in der Kontaktfahne (10), die auf der Metallisierung (4) der Isolierzwischenscheibe (13) des rechten Halbleiterkörpers (6') befestigt ist und damit die beiden Halbleiterkörper in der angegebenen Weise elektrisch verbindet.

Im dargestellten Ausführungsbeispiel bildet der linke Stromleitungsanschluß (11) mit dem Dehnungsbogen (12) den Eingang der elektrischen Reihenschaltung der beiden Halbleiterkörper (6, 6'), der linke Ansatz (9/10) den Verbindungsleiter mit der Metallisierung (4) der rechten Isolierzwischenscheibe (13) und damit mit dem rechten Stromleitungsanschluß (11) des rechten Halbleiterkörpers (6') und der mittlere Stromleitungsanschluß (14) den mit der oberen Kontaktelektrode des rechten Halbleiterkörpers (6') kontaktierten Ausgang der elektrischen Reihenschaltung. Die Schaltung und die Ausgestaltung der Stromleitungsanschlüsse ist nicht Teil der Erfindung und nur beschrieben, soweit dies die Anordnung der Halbleiterkörper mit Kontaktbauteilen gemäß der Erfindung betrifft.

Bei der unmittelbaren Befestigung jedes Halbleiterkörpers auf einer ganzflächig metallisierten Keramik und über diese auf einer metallischen Grundplatte (1) bildet die Isolierzwischenscheibe zusammen mit dem zugeordneten Abschnitt der Grundplatte eine Trägerplatte für den Halbleiterkörper mit größerer Flächenausdehnung als diejenige des Halbleiterkörpers. Als Trägerplatte kann auch nur eine metallisierte Isolierzwischenscheibe oder aber eine metallische Kontaktplatte, die bedarfsweise mit einem lötfähigen Überzug versehen ist, vorgesehen sein. In allen Fällen ist die Trägerplatte wenigstens in einem sich über den Halbleiterkörper hinaus erstreckenden Bereich der den Halbleiterkörper tragenden Fläche zur Stromleitung ausgebildet.

In Figur 2 ist insbesondere die räumliche Zuordnung der Bauteile jedes der beiden Aufbauten gemäß Figur 1 sowie die Ausgestaltung der Isolierzwischenscheiben (3, 13) auf ihrer oberen Kontaktfläche gezeigt. Die Keramik beider Zwischenscheiben (3, 13) weist zur Gewährleistung der geforderten Isolationsfestigkeit eine etwas größere Flächenausdehnung als ihre Metallisierung (4) auf. Der Ansatz (9') mit Kontaktfahne (10') des rechten Aufbaus ist auf einem getrennten Abschnitt (15) der oberen Metallisierung (4) der rechten Isolierzwischenscheibe (13) kontaktiert und auf diesem mit dem dort aufgebrachten einen Fuß des mittleren Anschlußleiters (14) galvanisch verbunden. Der andere Fuß des Anschlußleiters ist auf einem entsprechenden Abschnitt (16) der Metallisierung (4) der linken Isolierzwischenscheibe (3) elektrisch isoliert befestigt.

Die beiden Stapel aus Halbleiterkörper und zugehörigen Bauteilen sind achsparallel versetzt angeordnet. Dadurch wird eine günstige Verbindung der Halbleiterkörper und eine gedrängte räumliche und elektrische Zuordnung des Ausgangs (14) der Reihenschaltung zum rechten der beiden Stapel erreicht.

Die Dicke der Isolierscheiben (3, 13) ist durch die Vorgabe der elektrischen Isolationsfestigkeit einerseits und durch fertigungstechnische Gesichtspunkte andererseits bestimmt. Die Halbleiterkörper (6, 6') sind an ihrer Randzone für eine vorgegebene Sperrspannungsbelastbarkeit entsprechend ausgebildet. Dazu kann der Halbleiterkörper eine Abschrägung aufweisen oder aber mesaförmig ausgebildet sein. Die Halbleiteroberfläche ist im Bereich des Austritts des oder der pn-Übergänge mit einem passivierenden und stabilisierenden Überzug abgedeckt.

Mit einer Ausführungsform mit den Maßen 3 mm für die Grundplatte (1), 0,1 mm für die Lotmetallfolie (5, 5') zwischen Grundplatte (1) und Isolierzwischenscheiben (3, 13), 0,07 mm für die Lotmetallfolien beiderseits der Halbleiterkörper und 0,2 mm für die Lotmetallfolien zur Befestigung der Anschlußleiter (12, 12', 14) und Kontaktfahnen (10, 10') sowie mit einem Weichlot auf Zinnbasis mit Zusätzen an Kupfer und Indium wurden günstige Ergebnisse erzielt.

Die Ausbildung der Anordnung mit einer größeren Flächenausdehnung der Trägerplatte gegenüber dem Halbleiterkörper, die großflächige Stromleitung in der Trägerplatte sowie die direkte Verbindung von Halbleiterkörper und Trägerplatte liefern in überraschend günstiger Weise das gewünschte Betriebsverhalten bei gleichzeitiger Verringerung des Herstellungsaufwandes.

## Ansprüche

1. Halbleiterelement, dessen Halbleiterkörper
- eine Folge von schichtförmigen Zonen unterschiedlicher Leitfähigkeit und
- mindestens einen an der für hohes Sperrvermögen ausgebildeten Mantelfläche austretenden pn-Übergang aufweist sowie
- an einer seiner Hauptflächen auf einer Trägerplatte angeordnet ist,
**dadurch gekennzeichnet** , daß
- die Trägerplatte eine größere Flächenausdehnung als der Halbleiterkörper (6) aufweist sowie
- wenigstens in einem, sich über den Halbleiterkörper (6) hinaus erstreckenden Bereich der den Halbleiterkörper tragenden Fläche zur Stromleitung ausgebildet ist, und
- der Halbleiterkörper (6) unmittelbar auf dem zur Stromleitung ausgebildeten Bereich befestigt ist.

2. Halbleiterelement nach Anspruch 1, dadurch gekennzeichnet, daß der Halbleiterkörper (6) mittels einer Lötverbindung auf der Trägerplatte befestigt ist.

3. Halbleiterelement nach Anspruch 1, dadurch gekennzeichnet, daß die Trägerplatte aus einer metallischen Grundplatte (1) und einer auf dieser durch Löten befestigten, metallisierten Keramik besteht.

4. Halbleiterelement nach Anspruch 1, dadurch gekennzeichnet, daß die Trägerplatte aus einer Keramik besteht, die wenigstens in dem zur Stromleitung ausgebildeten Bereich eine lötfähige Metallisierung (4) aufweist.

5. Halbleiterelement nach Anspruch 4, dadurch gekennzeichnet, daß als Trägerplatte (3) eine Keramik mit aufgebondeter Metallisierung (4) vorgesehen ist.

6. Halbleiterelement nach Anspruch 1, dadurch gekennzeichnet, daß als Trägerplatte (3) eine metallische Kontaktplatte vorgesehen ist, die bedarfsweise eine die Lötkontaktierung fördernde Oberflächenbeschichtung aufweist.

Fig.1

Fig.2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | FR-A-2 381 388 (VARIAN ASSOCIATES INC.)<br>* Seite 3, Zeilen 2-14; Figuren 2,5 * | 1-4 | H 01 L 25/07 |
| Y | | 5 | |
| Y | IEEE CONFERENCE RECORD OF THE 1986 IEEE INDUSTRY APPLICATIONS SOCIETY ANNUAL MEETING, Denver, Colorado, US, 28. September - 3. Oktober 1986, Teil 1, Seiten 438-443; W. BRESCH et al.: "Future trends of power semiconductor modules"<br>* Seite 439, Absatz: "New principle of module design"; Figur 4 * | 5 | |
| A | IDEM | 1-4 | |
| X | FR-A-2 452 178 (GENERAL ELECTRIC CO.)<br>* Seite 7, Zeile 3 - Seite 11, Zeile 1; Figuren 2,3 * | 1-5 | |
| A | | 6 | RECHERCHIERTE SACHGEBIETE (Int. Cl.5) |
| A | IEEE CONFERENCE RECORD OF THE 1987 IEEE INDUSTRY APPLICATIONS SOCIETY ANNUAL MEETING, Atlanta, Georgia, US, Teil 1, 18.-23. Oktober 1987, Seiten 531-536; J. VITINS et al.: "New manufacturing technology for high voltage thyristors"<br>* Figuren 2A-2C * | 1 | H 01 L 25/07N |
| A | EP-A-0 150 347 (SIEMENS AG)<br>* Seite 3, Zeilen 7-16; Figur 1 *<br>---       -/- | 1-4,6 | |

Der vorliegende Recherchenbericht wurde für alle Patentansprüche erstellt

| Recherchenort | Abschlußdatum der Recherche | Prüfer |
|---|---|---|
| DEN HAAG | 28-02-1990 | ZEISLER P.W. |

Nummer der Anmeldung

EP   89 12 0447

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 163 163  (BBC)<br>* Seite 5, Zeile 1 - Seite 6, Zeile 4;<br>Figuren 2A,2B,3 *<br>----- | 1-5 | |

**RECHERCHIERTE SACHGEBIETE (Int. Cl.5)**

Der vorliegende Recherchenbericht wurde für alle Patentansprüche erstellt

| Recherchenort | Abschlußdatum der Recherche | Prüfer |
|---|---|---|
| DEN HAAG | 28-02-1990 | ZEISLER P.W. |

EPO FORM 1503 03.82 (P0403)